(19)

Europäisches
Patentamt
European
Patent Office
Office européen
des brevets

(11) **EP 2 977 776 A1**

(12) **EUROPEAN PATENT APPLICATION**

(43) Date of publication:
**27.01.2016 Bulletin 2016/04**

(21) Application number: **15177564.0**

(22) Date of filing: **20.07.2015**

(51) Int Cl.:
*G01R 33/04* (2006.01)          *G01R 15/18* (2006.01)
*G01R 19/20* (2006.01)          *G01R 31/02* (2006.01)

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**MA**

(30) Priority: **21.07.2014 DE 102014214160**

(71) Applicant: **TE Connectivity Germany GmbH
64625 Bensheim (DE)**

(72) Inventors:
• **STROSS, Stefan
69234 Dielheim (DE)**
• **BREIDENSTEIN, Gerd
35713 Eschenburg (DE)**

(74) Representative: **Grünecker Patent- und
Rechtsanwälte
PartG mbB
Leopoldstraße 4
80802 München (DE)**

(54) **METHOD AND DEVICE FOR DETECTING A RESIDUAL CURRENT IN A CHARGING CABLE AND CHARGING CABLE USING SAID DEVICE**

(57)  The present invention relates to a device for detecting a residual current in a cable, particularly a charging cable, wherein the cable has an outgoing conductor and a return conductor and connects a current source and a load such that the current source, the outgoing and the return conductors and the load form an electric circuit, and the residual current is a differential current between the current in the outgoing conductor and the current in the return conductor. The device has: a ring core for surrounding the outgoing conductor and the return conductor, wherein the ring core is formed from a material whose magnetisation characteristic line has an approximately linear region and a saturation region; a driving coil wound around the ring core in a poloidal direction and configured such that it receives a periodic excitation signal provided by a signal source; a measurement winding which is wound around the ring core in a poloidal direction and which provides a measurement signal corresponding to the magnetic flux density generated in the ring core; a signal processing apparatus which receives, at its input, the measurement signal provided by the measurement winding, wherein the maximum excursion of the excitation signal is selected such that the magnetic flux density generated by the excitation signal in the ring core has an approximately linear behaviour if the residual current is less than or equal to a first predetermined value, and has a saturation behaviour if the residual current is greater than the first predetermined value, the measurement signal provided by the measurement winding has distortions if the magnetic flux density generated by the excitation signal in the ring core has a saturation behaviour, and the signal processing apparatus is configured such that it recognises a residual current exceeding the first predetermined value by means of the distortions of the measurement signal, and outputs a status signal if the residual current exceeds a second predetermined value.

Fig. 6

**Description**

The present invention relates to a device for detecting a residual current, in particular a residual direct current, in a cable which has an outgoing conductor and a return conductor and connects a current source to a load such that the current source, the outgoing and the return conductors and the load form an electric circuit. The present invention further relates to a cable, in particular to a charging cable for charging up the battery in an electric vehicle/electric car which uses this device.

A residual current which is equal to the difference between the current in the outgoing conductor and the current in the return conductor can occur for instance if a current flows to earth through the human body or via a faulty insulation. In an intact cable, the residual current must be zero. In other words, the current which flows to the load must be just as large as the current which flows back from the load.

Devices for detecting a residual current are also known as Residual Current protective Devices, RCDs. Residual current protective devices for preventing dangerously high residual currents to earth are known in plant and building protection. These devices are very large and complex and cannot be integrated into a charging cable.

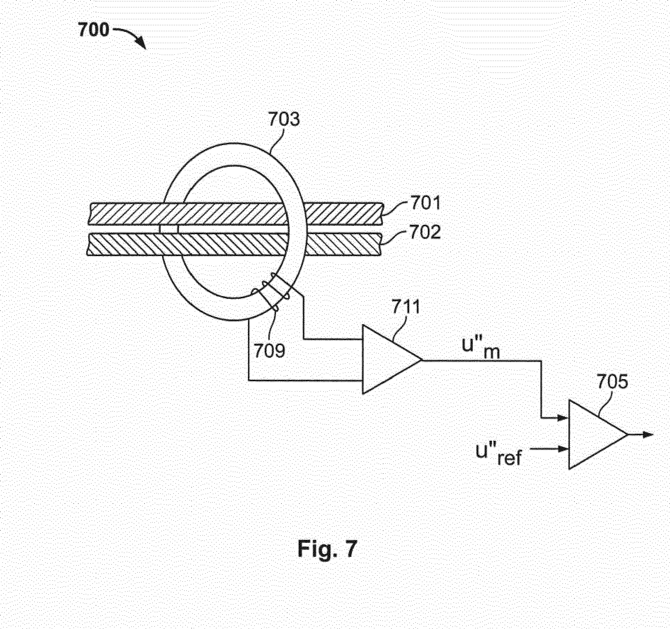

Charging cables used to charge up the battery in an electric car must currently have residual current protective devices for protection against residual alternating currents. A residual current protective device for protection against residual alternating currents is schematically depicted in Figure 7. The residual current protective device 700 shown in this figure comprises: a ring core 703, a measurement winding 709, an amplifier 711 and a comparator 705. The ring core 703 is configured such that it comprises the outgoing conductor 701 and the return conductor 702 of the cable. The measurement winding 709 is wound around the ring core 703 in a poloidal direction and configured such that it provides an electrical signal corresponding to the magnetic flux density induced in the ring core 703. The amplifier 711 receives the electrical signal provided by the measurement winding 709, amplifies it and feeds the amplified signal $U''_m$ to the comparator 705 which compares it with a reference value $U''_{ref}$ and generates a status signal dependent on the comparison result.

The known residual current protective device 700 shown in Figure 7 functions according to the transformer principle, i.e. a residual alternating current occurring in the charging cable induces in the ring core 703 a temporally variable magnetic flux density, which in turn induces in the measurement winding 709 a temporally changeable electrical signal. Since the transformer principle is only applicable to alternating currents, the known residual current protective device 700 is not suitable for detecting a residual direct current. However, in future charging cables for charging up electric vehicles will also have to offer protection against residual direct currents (IEC Standard 62752 CD).

An object of the present invention is therefore to provide a residual current protective device for use in charging cables for charging up electric vehicles, which can detect both residual alternating currents and residual direct currents, and to provide a charging cable which offers protection against residual alternating currents and residual direct currents.

This object is achieved by the subject-matters of the independent claims. Advantageous developments of the present invention are the subject-matter of the dependent claims.

The present invention is based on the idea that, in the ring core surrounding a charging cable, a periodically changing magnetic flux density is induced, the maximum excursion of which has a value which is very close to the saturation region of the magnetisation line of the ring core; the magnetic flux density in the ring core is detected by a measurement winding wound around the ring core; an electrical signal corresponding to the magnetic flux density detected by the measurement winding is fed to a signal processing unit; and this can recognise a residual current in the charging cable based on the shape of the electrical signal fed to it.

This is possible in the present invention because the occurrence of a residual current (alternating or direct current) in the charging cable leads to the occurrence of a magnetic flux density in the ring core, this is superimposed on the periodically changing magnetic flux density and thus raises or lowers the maximum excursion of the resulting magnetic flux density in the saturation region, depending on the direction of the residual current, and as a result the electrical signal fed to the signal processing unit is subjected to a distortion which correlates to the residual current.

Advantageously, the device (residual current protective device) according to the present invention can detect both a residual alternating current and a residual direct current in a cable and is additionally suitable for use in a charging cable.

The advantages according to the invention can be achieved particularly easily if the signal processing unit has a demodulation unit, for example a phase-selective amplifier or lock-in amplifier, and an integrator. The demodulation unit is configured such that it demodulates the electrical signal provided by the measurement winding and provides at its output a demodulated signal which correlates with the distortions of the electrical signal, and the integrator is configured such that it integrates/filters the signal demodulated by the demodulation unit and provides at its output a signal which has a level unambiguously corresponding to the residual current.

Advantageously, the sensitivity for discovering a residual current in a charging cable can be raised if the device has a compensation winding wound around the ring core, and a feedback resistor, the compensation winding being configured such that it receives a compensation signal from the output of the integrator via the feedback resistor, and

EP 2 977 776 A1

the feedback resistor is dimensioned such that the compensation signal in the ring core generates a magnetic flux density which compensates for the magnetic flux density generated by the residual current in the ring core. In this way, a working point is fixed on the magnetisation characteristic line of the ring core and thus disruptive effects caused by the non-linearity of the magnetisation characteristic line are eliminated.

To better understand the present invention, this is explained in greater detail with the aid of the embodiments depicted in the following figures. Identical parts are provided with identical reference numerals and identical component names. They show:

**Fig. 1**  a device for detecting a residual current in a charging cable according to the first embodiment of the present invention;

**Fig. 2**  the magnetisation characteristic line of the ring core;

**Fig. 3a**  the magnetisation characteristic line of the ring core with the field strengths generated by the maximum excursions of the excitation signal if no differential current (residual current) occurs in the charging cable;

**Fig. 3b**  the temporal progression of the excitation signal, which is, for example, a harmonic signal;

**Fig. 3c**  the temporal progression of the magnetic flux density in the ring core if no differential current (residual current) occurs in the charging cable;

**Fig. 4a**  the magnetisation characteristic line of the ring core with the field strength generated by the residual direct current $\Delta I_0$, the field strength generated by the residual direct current $\Delta I_0$ and the excursion of the excitation signal $+i_0$, and the field strength generated by the residual direct current $\Delta I_0$ and the excursion of the excitation signal $-i_0$ (corresponding to the first embodiment of the present invention);

**Fig. 4b**  the temporal progression of the residual direct current $\Delta I_0$;

**Fig. 4c**  the temporal progression of the magnetic flux density in the ring core if the residual direct current $\Delta I_0$ occurs in the charging cable;

**Fig. 5a**  the magnetisation characteristic line of the ring core with the field strength generated by the residual direct current $\Delta I'_0$, the field strength generated by the residual direct current $\Delta I'_0$ and the excursion of the excitation signal $+i'_0$, and the field strength generated by the residual direct current $\Delta I'_0$ and the excursion of the excitation signal $-i'_0$ (corresponding to the second embodiment of the present invention);

**Fig. 5b**  the temporal progression of the residual direct current $\Delta I'_0$;

**Fig. 5c**  the temporal progression of the magnetic flux density in the ring core if the residual direct current $\Delta I'_0$ occurs in the charging cable;

**Fig. 6**  a device for detecting a residual current in a charging cable according to the third embodiment of the present invention;

**Fig. 7**  a device for detecting a residual current (alternating current) in a charging cable according to the prior art.

*First embodiment*

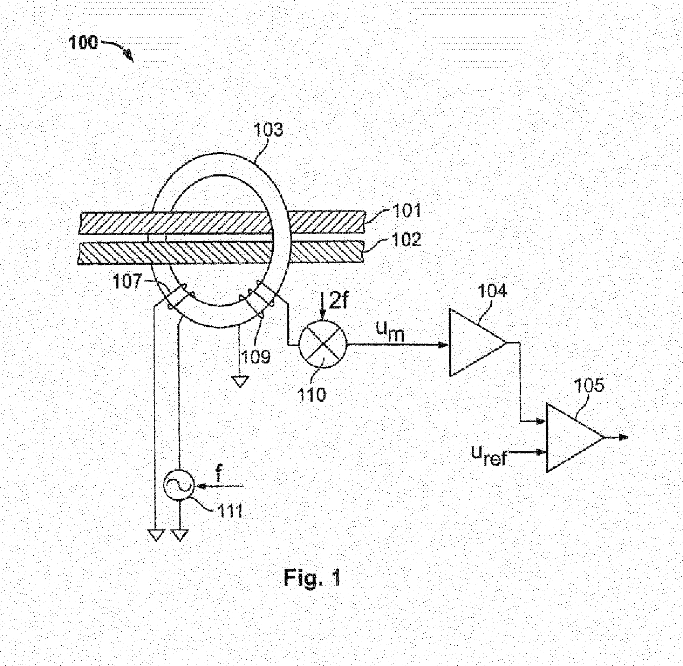

Figure 1 shows in schematic form a device for detecting a residual current in a charging cable according to the first embodiment of the invention. The charging cable has an outgoing conductor 101 and a return conductor 102, and connects a current source to a load such that the current source, the outgoing conductor, the return conductor and the load form an electric circuit. The current source and the load are not shown in Figure 1. In normal operation, i.e. when no current flows to earth from one of the two conductors 101 and 102, the difference between the current in the outgoing conductor 101 and the current in the return conductor 102 is equal to zero. The difference in these two currents is referred to as residual current (or also differential current). The residual current can be a direct current, an alternating current, or a combination of both. If a current flows from one of the two conductors 101 and 102 to earth, there occurs in the charging cable a residual current which is different from zero and which is detected/discovered by the device shown in Figure 1. In particular, the device shown in Figure 1 is suitable for detecting residual direct currents.

The device for detecting a residual current in a charging cable according to the first embodiment has a ring core 103, a driving coil 107, a measurement winding 109 and a signal processing device. The ring core 103 is preferably made from a magnetically soft material and is configured such that it can comprise the outgoing conductor 101 and the return conductor 102. It is important for the present invention that the material of which the ring core is made has a magnetisation characteristic line which has an approximately linear region and a saturation region. The driving coil 107 is wound around the ring core 103 in a poloidal direction and configured such that it receives a periodic excitation signal provided by a signal source 111. The excitation signal is preferably a harmonic signal or a square-wave signal and has a frequency substantially greater than the frequency of the charging current in the outgoing conductor and the return conductor. For example, the frequency of the excitation signal is 10 kHz if the charging current has a frequency of 50 Hz or 60 Hz. The measurement winding 109 is wound around the ring core 103 in a poloidal direction and provides at its ends a measurement signal corresponding to the magnetic flux density generated in the ring core 103. The signal processing device has a demodulation unit 110, an integrator 104 and a comparator 105. The demodulation unit 110 receives the measurement signal provided by the measurement winding 109 and at its output provides a demodulated signal $U_m$. The integrator 104 receives the signal $U_m$ provided by the demodulation unit 110 and provides at its output a signal which is fed to the comparator 105. The comparator 105 compares this to a reference voltage $U_{ref}$ and outputs a status signal if the signal received from the output of the integrator exceeds the reference voltage $U_{ref}$.

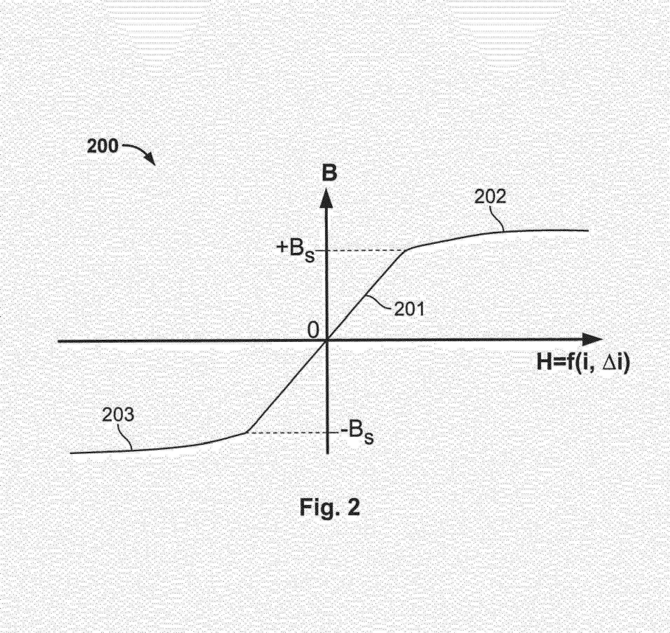

Figure 2 shows the magnetisation characteristic line 200 of the ring core. This reflects the dependency of the magnetic flux density B generated in the ring core 103 on the field strength H induced in the ring core. The field strength H induced in the ring core is in turn dependent on the excitation signal i which flows through the driving coil 107, on the residual current $\Delta i$ occurring in the charging cable, and on the position of the ring core relative to the outgoing and return conductors. The magnetisation characteristic line 200 has an approximately linear progression in its middle region 201. This is preferably linear. A saturation region 202 or 203 adjoins the two ends of the approximately linear region 201, respectively. The gradient of the magnetisation characteristic line 200 in the saturation regions 202 and 203 is at each point smaller than the gradient of the magnetisation characteristic line 200 in the approximately linear region 201. The magnetisation characteristic line 200 is preferably an odd function. In this case, $+B_S$ and $-B_S$ refer to the limits between the approximately linear region 201 and the respective saturation regions 202 and 203.

The selection of the maximum excursion of the excitation signal relative to the limits of the approximately linear region 201 is important for the invention. In the first embodiment of the present invention, the maximum excursion of the excitation signal is selected such that the magnetic flux density generated by the excitation signal in the ring core 103 has an approximately linear behaviour if no residual current occurs in the charging cable, and has a saturation behaviour if a residual current which is different from zero occurs in the charging cable.

In particular, in the first embodiment, if the middle region 201 is linear and the magnetisation characteristic line 200 is an odd function, the maximum excursion of the excitation signal is selected such that the magnetic flux density generated by the excitation signal in the ring core 103 linearly depends on the excitation signal if no residual current occurs in the charging cable, and does not linearly depend on the excitation signal if a residual current different from zero occurs in the charging cable.

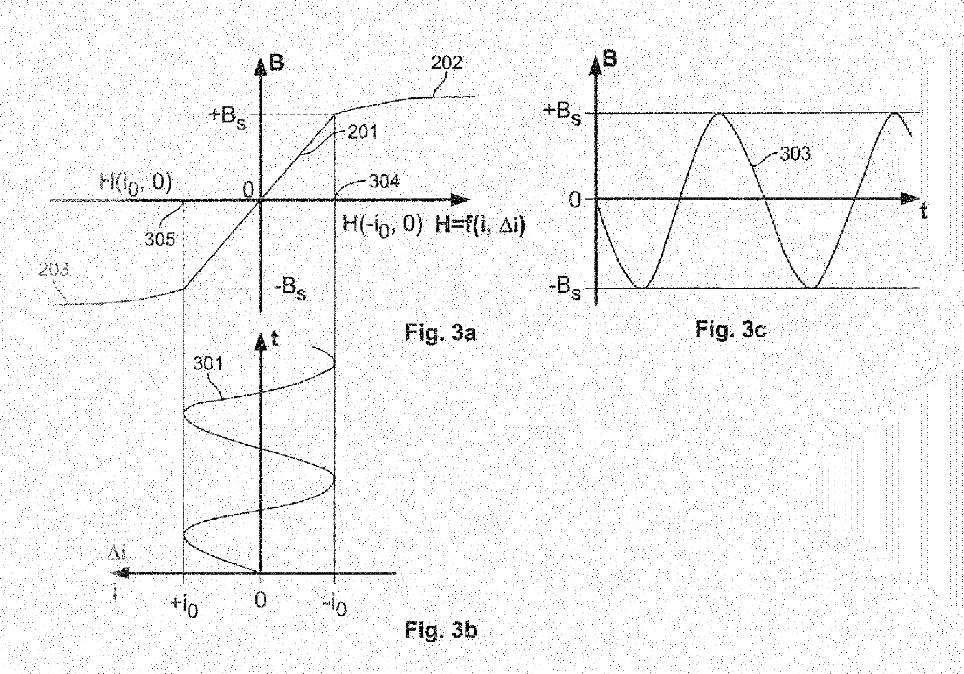

In other words, the maximum excursion of the excitation signal is selected such that the magnetic flux density generated by the maximum excursion of the excitation signal is equal to $+B_S$ or $-B_S$. Figures 3a, 3b and 3c clearly illustrate this for a harmonic excitation signal i with the amplitudes $+i_0$ and $-i_0$.

Figure 3b shows the temporal progression of a harmonic excitation signal 301 with the amplitudes $+i_0$ and $-i_0$.

Fig. 3a shows the magnetisation characteristic line of the ring core 103 and the field strengths induced by the positive and negative amplitudes of the excitation signal in the ring core 103 if no residual current occurs in the charging cable. The reference numeral 304 refers to the field strength induced by the negative amplitude $-i_0$ and the reference numeral 305 refers to the field strength induced by the positive amplitude $+i_0$. The magnetic flux density $+B_S$ corresponds to the field strength referred to by the reference numeral 304 and the magnetic flux density $-B_S$ corresponds to the field strength referred to by the reference numeral 305.

Fig. 3c shows the temporal progression 303 of the magnetic flux density generated by the harmonic excitation signal 301 in the ring core 103 if no residual current occurs in the charging cable. Since the magnetic flux density varies within the linear region 201 of the magnetisation characteristic line, the temporal progression 303 of the magnetic flux density is also harmonic. Its amplitudes are $+B_S$ and $-B_S$, respectively.

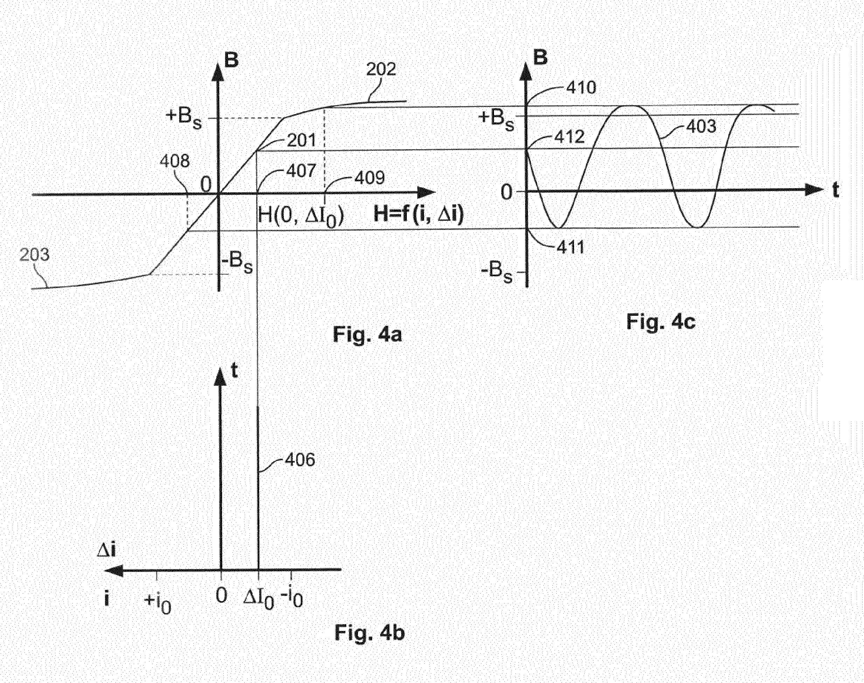

Figures 4a, 4b and 4c illustrate the effect of a residual current occurring in the charging cable on the temporal progression of the magnetic flux density induced in the ring core 103 in the first embodiment.

Figure 4b shows the temporal progression 406 of the residual direct current $\Delta I_0$ occurring in the charging cable.

Figure 4a shows the magnetisation characteristic line of the ring core 103; the field strength 407 generated by the residual direct current $\Delta I_0$ in the ring core 103; the resulting field strength 408 generated in the ring core 103 by the residual direct current $\Delta I_0$ and the positive amplitude $+i_0$ of the excitation signal 301 shown in Figure 3b; and the resulting field strength 409 generated in the ring core 103 by the residual direct current $\Delta I_0$ and the negative amplitude $-i_0$ of the excitation signal 301 shown in Figure 3b.

The region between the field strengths referred to with the reference numerals 408 and 409 is just as large as the region between the field strengths from Figure 3a referred to with the reference numerals 305 and 304 but, as a result of the occurrence of the residual direct current $\Delta I_0$ in the charging cable, is displaced to the right by the field strength $H(0, \Delta I_0)$ induced thereby in the ring core 103.

Fig. 4c shows the temporal progression 403 of the resulting magnetic flux density in the ring core 103 which is generated by the harmonic excitation signal 301 shown in Figure 3b and the residual direct current $\Delta I_0$ which is different from zero. The magnetic flux densities referred to with the reference numerals 410, 411 and 412 correspond to the field strengths from Figure 4a referred to with the reference numerals 409, 408 and 407, respectively.

Since the region between the field strengths indicated with the reference numerals 408 and 409 is no longer symmetrical with reference to the origin 0 of the magnetisation characteristic line, the progression 403 of the magnetic flux density is displaced either upwards or downwards, depending on whether the region between the field strengths referred to with the reference numerals 408 and 409 is displaced to the right or left, or whether the residual direct current $\Delta I_0$ occurring in the charging cable is negative or positive. The displacement of the region between the field strengths referred to by the reference numerals 408 and 409 leads to the progression 403 of the magnetic flux density in the ring core 103 exceeding the linear region 201 of the magnetisation characteristic line and entering into one of the saturation regions of the magnetisation characteristic line. The entry into one of the saturation regions 202 and 203 leads to a distortion/compression of the upper or lower half-wave of the progression 403. In Figure 4c, the positive (upper) half-wave is distorted.

In the present invention, the progression of the magnetic flux density in the ring core 103 is deemed to be distorted if its shape (significantly) deviates from the shape of the excitation signal, for example, from the harmonic progression 301 in Figure 3b.

The measurement signal provided by the measurement winding 109 has a shape which substantially corresponds to the shape of the temporal progression of the magnetic flux density generated in the ring core 103. This means that, if the temporal progression of the magnetic flux density generated in the ring core 103 is harmonic, for example, as shown in Figure 3c, then the measurement signal provided by the measurement winding 109 is also harmonic, and if the temporal progression of the magnetic flux density generated in the ring core 103 is distorted, as shown in Figure 4c, for example, then the measurement signal provided by the measurement winding 109 is also distorted.

In the present invention, the temporal progression 403 of the magnetic flux density induced in the ring core 103 is distorted by the saturation behaviour of the magnetisation characteristic line. Therefore, the measurement signal provided by the measurement winding 109 has a distortion if the magnetic flux density generated by the excitation signal in the ring core 103 has a saturation behaviour, i.e. the magnetic flux density generated by the excitation signal in the ring core 103 leaves the linear region 201 of the magnetisation characteristic line and enters one of the saturation regions 202 and 203. However, since in the first embodiment the saturation behaviour of the magnetic flux density generated in the ring core 103 is caused by the occurrence of a residual current which is different from zero, as shown in Figures 4a to 4c for example, the appearance of distortions in the measurement signal is correlated with the occurrence of a residual current in the charging cable.

As a result, in the present invention the signal processing device is configured such that it recognises a residual current, preferably a residual direct current, by means of the distortions in the measurement signal. The demodulation unit 110 is configured such that the demodulated signal $u_m$ provided at its output correlates with the distortions of the measurement signal, and the integrator 104 is configured such that the signal provided at its output has a level (unambiguously) corresponding to the residual current. Typically, the limit frequency of the integrator is 1 kHz if the frequency of the excitation signal is 10 kHz and that of the charging current is 50 Hz or 60 Hz.

Preferably, the signal processing device also outputs a status signal if the residual current exceeds a value determined by the reference voltage $U_{ref}$. The comparator 105 is configured in such a manner that it compares the signal provided by the output of the integrator 104 with a reference voltage $U_{ref}$ and outputs a status signal if the signal provided at the output of the integrator 104 exceeds the reference voltage $U_{ref}$.

Advantageously, the demodulation unit 110 can be produced as a phase-selective amplifier, in particular a lock-in amplifier, which, at one input, receives the measurement signal provided by the measurement winding (109) and, at another input, receives a reference signal. Preferably, the reference signal has a frequency which is two times greater than the frequency of the excitation signal. In this case, it is also possible to detect residual alternating currents with the present invention.

*Second embodiment*

The second embodiment of the present invention has substantially the same structure as the first embodiment shown in Figure 1. However, it differs from this in the selection of the maximum excursion of the excitation signal.

In the second embodiment of the present invention, the maximum excursion of the excitation signal is selected such that the magnetic flux density generated by the excitation signal in the ring core 103 has an approximately linear behaviour if the residual current is less than or equal to a predetermined value, and has a saturation behaviour if the residual current is greater than the predetermined value.

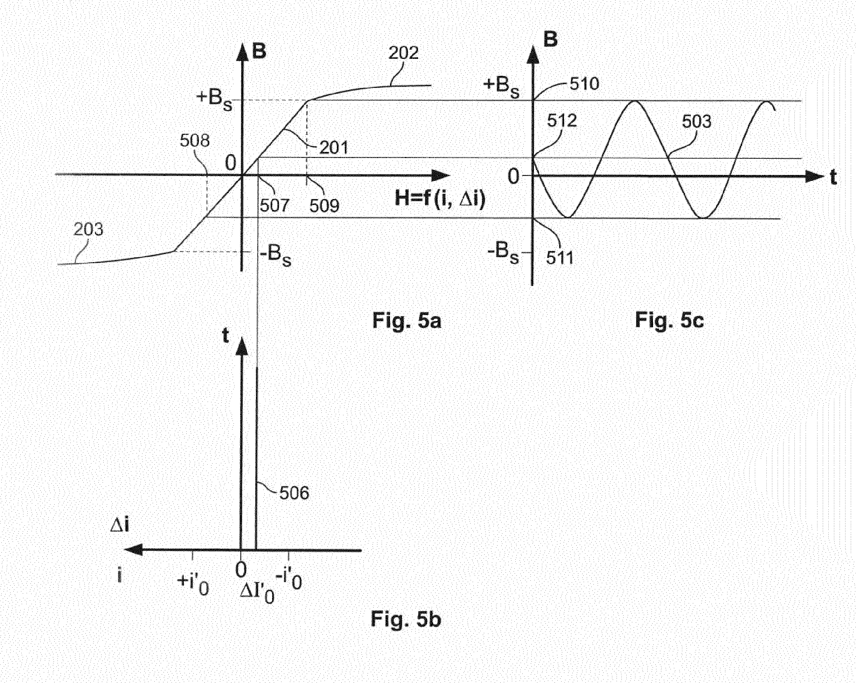

In particular, in the second embodiment, if the middle region 201 is linear and the magnetisation characteristic line is an odd function, the maximum excursion of the excitation signal is selected such that the magnetic flux density generated by the excitation signal in the ring core 103 linearly depends on the excitation signal if the residual current is less than or equal to a predetermined value, and does not linearly depend on the excitation signal if the residual current is greater than the predetermined value. Figures 5a, 5b and 5c clearly illustrates this for a harmonic excitation signal i' with the amplitudes $+i'_0$ und $-i'_0$. This excitation signal is not depicted in the figures.

Fig. 5b shows the progression 506 of a residual direct current with the predetermined value $\Delta I'_0$.

Figure 5a shows the magnetisation characteristic line of the ring core 103; the field strength 507 generated by the residual direct current $\Delta I'_0$ in the ring core; the resulting field strength 508 generated in the ring core 103 by the residual direct current $\Delta I'_0$ and the positive amplitude $+i'_0$ of the excitation signal; and the resulting field strength 509 which is generated in the ring core 103 by the residual direct current $\Delta I'_0$ and the negative amplitude of the excitation signal $-i'_0$.

Fig. 5c shows the temporal progression 503 of the resulting magnetic flux density in the ring core 103 which is generated by the harmonic excitation signal i' and the residual direct current $\Delta I'_0$ which is different from zero. The magnetic flux densities referred to with the reference numerals 510, 511 and 512 correspond to the field strengths referred to with the reference numerals 509, 508 and 507, respectively.

Figure 5c makes clear that, in the second embodiment of the present invention, the amplitude of the excitation signal i' has been selected such that formula (1) applies.

$$B(0, \Delta I'_0) + B(-i'_0, 0) = +B_S, \hspace{3cm} (1)$$

Here, $B(0, \Delta I'_0)$ is the magnetic flux density generated in the ring core 103 by the (negative) residual direct current $\Delta I'_0$, $B(-i'_0, 0)$ is the magnetic flux density generated in the ring core 103 by the negative amplitude $-i'_0$ of the harmonic excitation signal and $+B_S$ is the limit between the (approximately) linear region 201 and the saturation region 202 of the magnetisation characteristic line.

In Figure 5a, the limits $+B_S$ and $-B_S$ have the same absolute value. However, the present invention is not limited to this embodiment, but rather also comprises embodiments in which the limits between the approximately linear region and the saturation regions have different absolute values.

It is easy to realise that in the second embodiment of the present invention the progression 503 of the magnetic flux density induced in the ring core 103 will then intrude into the saturation region 202, and thus the measurement signal provided by the measurement winding 109 will have a distortion/compression if the residual direct current occurring in the charging cable exceeds the predetermined value $\Delta I'_0$ (in the absolute value). Accordingly, the level of the signal provided at the output of the integrator 104 will also only unambiguously correspond to the residual current occurring in the charging cable if this current is greater than the predetermined value $\Delta I'_0$.

*Third embodiment*

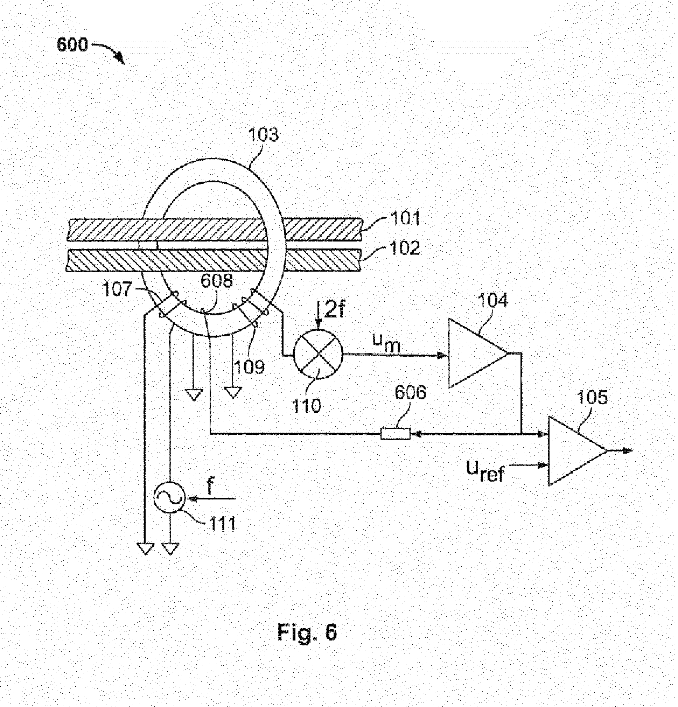

Figure 6 shows in schematic form a device for detecting a residual current in a charging cable according to the third embodiment of the invention. In addition to the features of the first/second embodiments, this also has a compensation winding 508 and a feedback resistor 606. The compensation winding 608 is wound around the ring core 103 in a poloidal direction and configured such that it receives a compensation signal from the output of the integrator 104 via the feedback resistor 606. The feedback resistor 606 is dimensioned such that the compensation signal in the ring core 103 generates a magnetic flux density which compensates for the magnetic flux density generated by the residual current in the ring core 103 if the residual current occurring in the cable is greater than zero or greater than the predetermined value $\Delta I'_0$.

By compensating for the magnetic flux density generated by the residual current in the ring core 103, a working point is fixed in the linear region of the magnetisation characteristic line, and thus the influence of any non-linearities decreases in the middle region 201 of the magnetisation characteristic line.

In the embodiments shown in Figures 1 and 5, outgoing and return conductors of the charging cable are arranged in the middle of the ring core and parallel with the axis of rotation (main axis) of the ring core. However, this is not significant for the present invention. On the contrary, the present invention also comprises embodiments in which outgoing and return conductors of the charging cable are not arranged in the middle of the ring core, and embodiments in which each of the two conductors, outgoing conductor or return conductor, is at any angle to the axis of rotation of the ring core, as is the case, for example, in cables with twisted conductors.

The present invention is not limited to charging cables, but rather can be applied to any cable which has an outgoing conductor and return conductor and which is configured such that it connects a current source to a load, that the current source, outgoing conductor and return conductor and load form an electric circuit such that no residual current can occur in normal operation.

The present invention can preferably be applied to charging cables for electric vehicles, and, in the case of a charging current of 10 - 20 A (alternating current), they can detect residual alternating currents in the range from 15 - 30 mA and residual direct currents of approximately 6 mA.

List of reference numerals:

| Reference numeral | Description |
|---|---|
| 100 | Device for detecting a residual current in a charging cable according to the first embodiment |
| 101 | Outgoing conductor of the charging cable |
| 102 | Return conductor of the charging cable |
| 103 | Ring core |
| 104 | Integrator |
| 105 | Comparator |
| 107 | Driving coil |
| 109 | Measurement winding |
| 110 | 2f demodulation unit |
| 111 | Signal source |
| 200 | Magnetisation characteristic line |
| 201 | Linear region of the magnetisation characteristic line |
| 202 | Saturation region of the magnetisation characteristic line |
| 203 | Saturation region of the magnetisation characteristic line |
| 301 | Progression of the excitation signal (current) |
| 303 | Magnetic flux density in the ring core if the residual current is equal to zero |
| 304 | Portion of the field strength in the ring core which corresponds to the excitation current $-i_0$ |
| 305 | Portion of the field strength in the ring core which corresponds to the excitation current $+i_0$ |
| 403 | Magnetic flux density in the ring core if the residual current is not equal to zero. |
| 406 | Residual direct current (constant differential current) |
| 407 | Portion of the field strength in the ring core which corresponds to the residual direct current $\Delta I_0$ |
| 408 | Resulting field strength in the ring core which corresponds to the excitation current $+i_0$ in the presence of the residual direct current $\Delta I_0$ |
| 409 | Resulting field strength in the ring core which corresponds to the excitation current $-i_0$ in the presence of the residual direct current $\Delta I_0$ |
| 410 | Magnetic flux density in the ring core, which corresponds to the resulting field strength 409 |
| 411 | Magnetic flux density in the ring core, which corresponds to the resulting field strength 408 |
| 412 | Magnetic flux density in the ring core, which corresponds to the field strength 407 |
| 506 | Residual direct current |
| 507 | Portion of the field strength in the ring core which corresponds to the residual direct current $\Delta I'_0$ |
| 508 | Resulting field strength in the ring core which corresponds to the excitation current $+i'_0$ in the presence of the residual direct current $\Delta I'_0$ |

(continued)

| Reference numeral | Description |
|---|---|
| 509 | Resulting field strength in the ring core which corresponds to the excitation current $-i'_0$ in the presence of the residual direct current $\Delta I'_0$ |
| 510 | Magnetic flux density in the ring core, which corresponds to the resulting field strength 509 |
| 511 | Magnetic flux density in the ring core, which corresponds to the resulting field strength 508 |
| 512 | Magnetic flux density in the ring core, which corresponds to the field strength 507 |
| 600 | Device for detecting a residual current in a charging cable according to the second embodiment |
| 606 | Resistor |
| 608 | Compensation winding |
| 700 | Device for detecting a residual current in a charging cable according to the prior art |
| 701 | Outgoing conductor of the charging cable |
| 702 | Return conductor of the charging cable |
| 703 | Ring core |
| 705 | Comparator |
| 709 | Measurement winding |
| 711 | Amplifier |

**Claims**

1. A device for detecting a residual current in a cable, wherein the cable has an outgoing conductor and a return conductor and connects a current source and a load such that the current source, the outgoing and the return conductors and the load form an electric circuit, and the residual current is equal to the difference between the current in the outgoing conductor (101) and the current in the return conductor (102), the device (100, 500) has:

    a ring core (103) for surrounding the outgoing conductor and the return conductor (101, 102), wherein the ring core (103) is formed from a material whose magnetisation characteristic line (200) has an approximately linear region (201) and a saturation region (202,203), a driving coil (107) wound around the ring core (103) in a poloidal direction and configured such that it receives a periodic excitation signal provided by a signal source (111), a measurement winding (109) which is wound around the ring core (103) in a poloidal direction and which provides a measurement signal corresponding to the magnetic flux density generated in the ring core (103), a signal processing apparatus (104, 105, 110) which receives, at its input, the measurement signal provided by the measurement winding (109), wherein the maximum excursion of the excitation signal is selected such that the magnetic flux density generated by the excitation signal in the ring core (103) has an approximately linear behaviour if the residual current is less than or equal to a first predetermined value, and has a saturation behaviour if the residual current is greater than the first predetermined value, the measurement signal provided by the measurement winding (109) has distortions if the magnetic flux density generated by the excitation signal in the ring core (103) has a saturation behaviour, and the signal processing apparatus (104, 105, 110) is configured such that it recognises a residual current exceeding the first predetermined value by means of the distortions of the measurement signal, and outputs a status signal if the residual current exceeds a second predetermined value (Uref).

2. The device according to claim 1, wherein the current in the outgoing and the return conductors (101, 102) of the cable is an alternating current, and the frequency of the periodic excitation signal is much greater than the frequency of the alternating current in the outgoing and the return conductors of the cable.

**3.** The device according to either of claims 1 or 2, wherein the approximately linear region (201) of the magnetisation characteristic line (200) is a linear region,
the maximum excursion of the excitation signal is selected such that the magnetic flux density generated by the excitation signal in the ring core (103) linearly depends on the excitation signal if the residual current is less than or equal to the first predetermined value, and does not linearly depend on the excitation signal if the residual current is greater than the first predetermined value.

**4.** The device according to any one of claims 1 to 3, wherein the first predetermined value is equal to zero.

**5.** The device according to any one of claims 1 to 4, wherein the periodic excitation signal is a harmonic signal and the maximum excursion is the amplitude of the harmonic signal, or
the periodic excitation signal is a square-wave signal.

**6.** The device according to any one of claims 1 to 5, wherein the signal processing apparatus has:

a demodulation unit (110) for demodulating the measurement signal provided by the measurement winding (109), wherein the demodulation unit is configured such that it provides at its output a demodulated signal ($u_m$), which correlates with the distortions of the measurement signal,
an integrator (104) which receives the demodulated signal provided at the output of the demodulation unit (110) and which is configured such that it integrates/filters the demodulated signal and provides at its output a signal which has a level unambiguously corresponding to the residual current if the residual current occurring in the cable is greater than the first predetermined value, and
a comparator (105) for comparing the signal provided at the output of the integrator (104) with a reference voltage ($U_{ref}$) and for outputting the status signal if the signal provided at the output of the integrator (104) exceeds the reference voltage ($U_{ref}$).

**7.** The device according to claim 6, wherein the demodulation unit (110) is a phase-selective amplifier, in particular a lock-in amplifier, which, at one input, receives the measurement signal provided by the measurement winding (109) and, at another input, receives a reference signal.

**8.** The device according to claim 7, wherein the reference signal has a frequency which is two times greater than the frequency of the excitation signal.

**9.** The device according to any one of claims 6 to 8, which further has a compensation winding (508) and a feedback resistor (606),
wherein the compensation winding (608) is wound around the ring core (103) in a poloidal direction and configured such that it receives a compensation signal from the output of the integrator (104) via the feedback resistor (606), and
the feedback resistor (606) is dimensioned such that the compensation signal in the ring core (103) generates a magnetic flux density which compensates for the magnetic flux density generated by the residual current in the ring core (103) if the residual current occurring in the cable is greater than the first predetermined value.

**10.** The device according to any one of claims 1 to 9, wherein the residual current is a residual direct current.

**11.** The device according to any one of claims 1 to 10, wherein the current source is the mains connection of a power supplier and the load is the battery of an electrical consumer, in particular an electric vehicle.

**12.** A cable for connecting a current source to a load has:

an outgoing and a return conductor (101, 102), which are both configured to connect the current source and the load to one another in such a manner that the current source, outgoing conductor and return conductor and the load form an electric circuit,
a device (100, 500) for detecting a residual current according to any one of claims 1 to 11, and
the ring core (103) of the device (100, 500) for detecting the residual current encloses/surrounds the outgoing and the return conductors (101, 102).

**13.** The cable according to claim 12, wherein the outgoing and return conductors are arranged approximately in the middle of the ring core.

14. The cable according to claim 13, wherein the outgoing and return conductors are arranged parallel with the axis of rotation of the ring core or are twisted with one another.

15. A charging cable for charging the battery of an electrical consumer, in particular an electric vehicle, which has a cable according to any one of claims 12 to 14.

16. A method for detecting a residual current in a cable, preferably in a charging cable, which has an outgoing conductor and a return conductor and connects a current source and a load such that the current source, the outgoing and the return conductors and the load form an electric circuit, the residual current being equal to the difference between the current in the outgoing conductor (101) and the current in the return conductor (102), comprises the following steps:

inducing a periodically changing magnetic flux density in a ring core (103) which surrounds the outgoing conductor and the return conductor (101, 102) and which is configured from a material whose magnetisation characteristic line (200) has an approximately linear region (201) and a saturation region (202, 203),
wherein the maximum excursion of the periodically changing magnetic flux density in the ring core (103) has a value which is close to the saturation region (202, 203) of the magnetisation line of the ring core (103), preferably adjacent thereto,
detecting the magnetic flux density in the ring core (103) by a measurement winding (109) wound around the ring core,
feeding an electrical signal to a signal processing unit which corresponds to the magnetic flux density detected by the measurement winding (109), and
recognising a residual current in the cable based on the shape of the electrical signal fed to the signal processing unit.

100

103

101

102

107

109

110

2f

$u_m$

104

105

$u_{ref}$

f

111

**Fig. 1**

Fig. 2

Fig. 3a

Fig. 3b

Fig. 3c

**Fig. 4a**

**Fig. 4c**

**Fig. 4b**

**Fig. 5a**

**Fig. 5c**

**Fig. 5b**

EP 2 977 776 A1

**Fig. 6**

**Fig. 7**

Europäisches
Patentamt

European
Patent Office

Office européen
des brevets

## EUROPEAN SEARCH REPORT

Application Number

EP 15 17 7564

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | JP 2003 075475 A (YOKOGAWA ELECTRIC CORP) 12 March 2003 (2003-03-12) * paragraph [0019] - paragraph [0027]; figures 1,3,5 * | 1-5, 10-16 | INV. G01R33/04 G01R15/18 G01R19/20 |
| X | US 2012/038360 A1 (LENGLET LUC LUCIEN MARIE [FR]) 16 February 2012 (2012-02-16) * paragraphs [0094], [0006], [0119] - paragraph [0129]; figure 1 * | 1,10-16 | ADD. G01R31/02 |
| X | WO 2013/137253 A1 (FERROTEC CORP) 19 September 2013 (2013-09-19) * figures 1,2,5,6 * * page 1, paragraph 7 - paragraph 12 * | 1,6-10, 16 | |
| X | WO 2012/007195 A1 (SIEMENS AG [DE]; MIN YING ZONG [CN]; DANKERT MARIO [DE]; DU FENG [CN];) 19 January 2012 (2012-01-19) * page 1, line 6 - line 12; figures 1,2,5 * * page 6, line 28 - page 7, line 28 * | 1,3,5, 10,16 | |
| A | JP H09 113543 A (TAKAOKA ELECTRIC MFG CO LTD) 2 May 1997 (1997-05-02) * abstract; figures 1,3 * | 1,16 | TECHNICAL FIELDS SEARCHED (IPC) G01R |
| A | EP 2 595 170 A1 (PANASONIC CORP [JP]) 22 May 2013 (2013-05-22) * paragraphs [0001], [0002], [0019]; figure 1 * | 10-16 | |
| A | WO 2012/038478 A1 (SHAKIRA LTD [IE]; GOINGA YDO [NL]) 29 March 2012 (2012-03-29) * figures 6,7 * | 10-15 | |
| A,P | US 2014/320112 A1 (NODERA TOSHIO [JP] ET AL) 30 October 2014 (2014-10-30) * the whole document * | 1-16 | |

-/--

The present search report has been drawn up for all claims

| Place of search | Date of completion of the search | Examiner |
|---|---|---|
| Munich | 23 November 2015 | Hof, Klaus-Dieter |

EPO FORM 1503 03.82 (P04C01)

Europäisches
Patentamt

European
Patent Office

Office européen
des brevets

**EUROPEAN SEARCH REPORT**

Application Number

EP 15 17 7564

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | & WO 2013/128803 A1 (FUJI ELECTRIC FA COMPONENTS & SYSTEMS CO) 6 September 2013 (2013-09-06) * paragraph [0044] - paragraph [0047]; figures 1,5-9 * ----- | 1-16 | |

TECHNICAL FIELDS
SEARCHED (IPC)

The present search report has been drawn up for all claims

| Place of search | Date of completion of the search | Examiner |
|---|---|---|
| Munich | 23 November 2015 | Hof, Klaus-Dieter |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

................................................................................

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 15 17 7564

This annex lists the patent family members relating to the patent documents cited in the above-mentioned European search report.
The members are as contained in the European Patent Office EDP file on
The European Patent Office is in no way liable for these particulars which are merely given for the purpose of information.

23-11-2015

| Patent document cited in search report | | Publication date | Patent family member(s) | | Publication date |
|---|---|---|---|---|---|
| JP 2003075475 | A | 12-03-2003 | NONE | | |
| US 2012038360 | A1 | 16-02-2012 | CN | 101305291 A | 12-11-2008 |
| | | | EP | 1932008 A1 | 18-06-2008 |
| | | | FR | 2891917 A1 | 13-04-2007 |
| | | | JP | 2009511868 A | 19-03-2009 |
| | | | JP | 2013235010 A | 21-11-2013 |
| | | | KR | 20080059288 A | 26-06-2008 |
| | | | US | 2008252289 A1 | 16-10-2008 |
| | | | US | 2012038360 A1 | 16-02-2012 |
| | | | WO | 2007042646 A1 | 19-04-2007 |
| WO 2013137253 | A1 | 19-09-2013 | CN | 104169727 A | 26-11-2014 |
| | | | EP | 2840400 A1 | 25-02-2015 |
| | | | JP | 2013217914 A | 24-10-2013 |
| | | | KR | 20140133928 A | 20-11-2014 |
| | | | US | 2015028857 A1 | 29-01-2015 |
| | | | WO | 2013137253 A1 | 19-09-2013 |
| WO 2012007195 | A1 | 19-01-2012 | CN | 102338822 A | 01-02-2012 |
| | | | EP | 2593799 A1 | 22-05-2013 |
| | | | WO | 2012007195 A1 | 19-01-2012 |
| JP H09113543 | A | 02-05-1997 | NONE | | |
| EP 2595170 | A1 | 22-05-2013 | CN | 102985992 A | 20-03-2013 |
| | | | EP | 2595170 A1 | 22-05-2013 |
| | | | US | 2013120892 A1 | 16-05-2013 |
| | | | WO | 2012008088 A1 | 19-01-2012 |
| WO 2012038478 | A1 | 29-03-2012 | EP | 2619596 A1 | 31-07-2013 |
| | | | US | 2013162242 A1 | 27-06-2013 |
| | | | WO | 2012038478 A1 | 29-03-2012 |
| US 2014320112 | A1 | 30-10-2014 | CN | 104067134 A | 24-09-2014 |
| | | | EP | 2821800 A1 | 07-01-2015 |
| | | | JP | 2013178205 A | 09-09-2013 |
| | | | KR | 20140136917 A | 01-12-2014 |
| | | | US | 2014320112 A1 | 30-10-2014 |
| | | | WO | 2013128803 A1 | 06-09-2013 |

EPO FORM P0459

For more details about this annex : see Official Journal of the European Patent Office, No. 12/82